# EUROPEAN PATENT APPLICATION

(11) **EP 2 448 382 A1**
(43) Date of publication of application: **02.05.2012**
(21) Application number: 09846484.5
(22) Date of filing: 23.06.2009
(51) Int. Cl.: H05K 3/10, B23K 20/10, H01R 4/02

(54) **ELECTRODE BASE**

(71) Applicant: Toshiba Mitsubishi-Electric Industrial Systems Corporation, Minato-ku Tokyo 108-0073 (JP)
(72) Inventor: YOSHIDA Akio, Tokyo 108-0073 (JP); KOGURA Masahisa, Tokyo 108-0073 (JP)
(74) Representative: HOFFMANN EITLE
(86) International application number: PCT/JP2009/061385
(87) International publication number: WO 2010/150351

(57) **Abstract**

An object of the present invention is to provide an electrode base in which an electrode capable of exhibiting a good external signal transmission function is formed on a surface of a thin-film base. In the present invention, a lead wire (2) made of aluminum is bonded to a surface of a glass substrate (3) that is a thin-film base having a plate thickness of about 0.7 to 2.0 mm, by using an ultrasonic bonding method. An external lead-out electrode (23) made of copper is formed so as to extend from a surface of one end portion of the lead wire (2) to a region outside the glass substrate (3). The lead wire 2 functions as an internal signal receiver, and the external lead-out electrode (23) has an external signal transmission function.

## Description

### TECHNICAL FIELD

The present invention relates to an electrode base having a structure in which an electrode is bonded to a surface of a base such as a glass substrate by an ultrasonic bonding process.

### BACKGROUND ART

An ultrasonic bonding apparatus can be mentioned as an apparatus for bonding an aluminum-based material to a steel material that is a dissimilar metal with a high bonding strength or as an apparatus for bonding a to-be-bonded member such as a lead wire for external connection onto a bonding object portion of an electronic device or the like. In ultrasonic bonding utilizing ultrasonic vibration produced by the ultrasonic bonding apparatus, a stress caused by vertical pressure application to a bonding interface and a repetitive stress caused by a high vibration acceleration in a parallel direction are given so that frictional heat is generated in the bonding interface. Thereby, atoms of an electrode material are diffused and thus bonding can be made. Such an ultrasonic bonding apparatus includes an ultrasonic bonding tool having a chip portion that is brought into contact with an electrode. This ultrasonic bonding tool is disclosed in, for example, Patent Document 1.

### PRIOR-ART DOCUMENTS

### PATENT DOCUMENTS

Patent Document 1: Japanese Patent Application Laid-Open No. 2005-254323

### SUMMARY OF THE INVENTION

### PROBLEMS TO BE SOLVED BY THE INVENTION

Here, as described above, the ultrasonic bonding apparatus performs an ultrasonic bonding operation in which both the application of pressure from the upper side and the application of ultrasonic vibration are made. Thus, the bonding object portion needs to be resistant to the ultrasonic bonding operation. Therefore, in apparatuses including the ultrasonic bonding apparatus disclosed in the Patent Document 1, it is not assumed that a thin-film base, such as a glass substrate, having a relatively small plate thickness and thus having a small resistance is used as the bonding object portion mentioned above, and means for bonding an electrode onto a surface of the thin-film base has not been considered. In other words, there has been a problem that it is difficult to obtain an electrode base having an electrode directly bonded to a surface of a thin-film base such as a glass substrate. This problem is particularly significant when the plate thickness of the thin-film base is 2 mm or less.

Additionally, one of important functions of the electrode is an external signal transmission function for at least either one of outputting a signal to the outside and receiving a signal from the outside.

However, conventionally, there has been a problem that it is substantially difficult to form, on a surface of a thin-film base, an electrode having good ultrasonic bonding characteristics and being excellent in the external signal transmission function.

An object of the present invention is to solve the above-described problems and to provide an electrode base having, on a surface of a thin-film base, an electrode capable of performing a good external signal transmission function.

### MEANS FOR SOLVING THE PROBLEMS

An electrode base according to the present invention includes: a thin-film base; a first electrode portion made of a first material and bonded to a surface of the thin-film base; and a second electrode portion made of a second material and electrically connected to the first electrode portion, the second electrode portion having an external signal transmission function for at least either one of outputting a signal to the outside and receiving a signal from the outside, wherein the first material is better than the second material in terms of bonding characteristics of bonding to the thin-film base by an ultrasonic bonding method.

### EFFECTS OF THE INVENTION

In the electrode base according to the present invention, the first material forming the first electrode portion is better than the second material forming the second electrode portion in terms of the bonding characteristics of bonding to the thin-film base by the ultrasonic bonding method.

Accordingly, the first electrode portion serves to keep good bonding property for bonding to the thin-film base by the ultrasonic bonding method, and additionally a material having good characteristics as an external signal transmission function is selectable as the second material forming the second electrode portion. Therefore, an electrode base including an electrode that exhibits a higher performance can be obtained, as compared with a case where the electrode is made of a single material.

These and other objects, features, aspects and advantages of the present invention will become more apparent from the following detailed description of the present invention when taken in conjunction with the accompanying drawings.

### BRIEF DESCRIPTION OF THE DRAWINGS

[FIG. 1] An explanatory diagram showing a planar structure and a cross-sectional structure of an electrode base according to an embodiment 1 of the present invention.
[FIG. 2] A cross-sectional view schematically showing a status of ultrasonic bonding performed by an ultrasonic bonding tool for manufacturing the electrode base according to the embodiment 1 of the present invention.
[FIG. 3] A cross-sectional view showing a cross-sectional structure of a surface portion of a chip portion of the ultrasonic bonding tool shown in FIG. 2.
[FIG. 4] A perspective view schematically showing a planar structure of the surface portion of the chip portion of the ultrasonic bonding tool shown in FIG. 2.
[FIG. 5] A cross-sectional view showing a cross-sectional structure of a surface portion of an ordinary chip portion of an ultrasonic bonding tool.
[FIG. 6] An explanatory diagram showing a planar structure and a cross-sectional structure of an electrode base according to an embodiment 2 of the present invention.
[FIG. 7] An explanatory diagram showing a planar structure and a cross-sectional structure of an electrode base according to an embodiment 3 of the present invention.

### EMBODIMENT FOR CARRYING OUT THE INVENTION

### <Embodiment 1>

### (Structure)

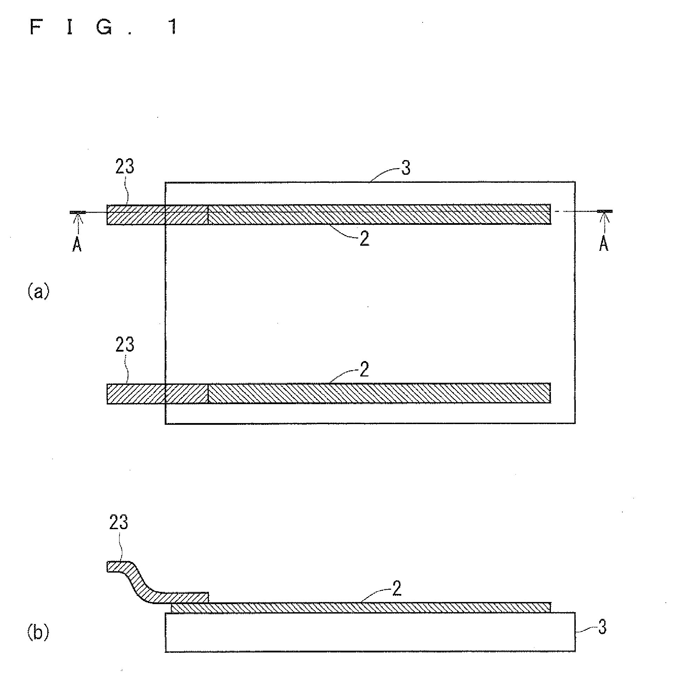

FIG. 1 is an explanatory diagram showing a planar structure and a cross-sectional structure of an electrode base according to an embodiment 1 of the present invention. FIG. 1(a) is a plan view as seen from the upper side, and FIG. 1(b) is a cross-sectional view showing a cross-section taken along the line A-A of FIG. 1 (a).

As shown in FIG. 1, by using an ultrasonic bonding method, lead wires 2 made of an aluminum material are bonded to a surface of a glass substrate 3 that is a thin-film base having a plate thickness of about 0.7 to 2.0 mm. Then, external lead-out electrodes 23 (lead wires) made of a copper material are formed on a surface of one end portion of the lead wire 2 so as to extend to a region outside the glass substrate 3. As shown in FIG. 1(b), in a cross-sectional view, the external lead-out electrode 23 is slightly raised upward along a direction toward the region outside the glass substrate 3.

The lead wire 2 functions as an internal signal receiver for receiving an electrical signal from a circuit or the like provided in the glass substrate 3. The external lead-out electrode 23 has an external signal transmission function for at least either one of outputting a signal to the outside and receiving a signal from the outside. In other words, a signal flow includes only one direction (from the glass substrate 3 to the outside or from the outside to the glass substrate 3).

### (Ultrasonic Bonding Tool)

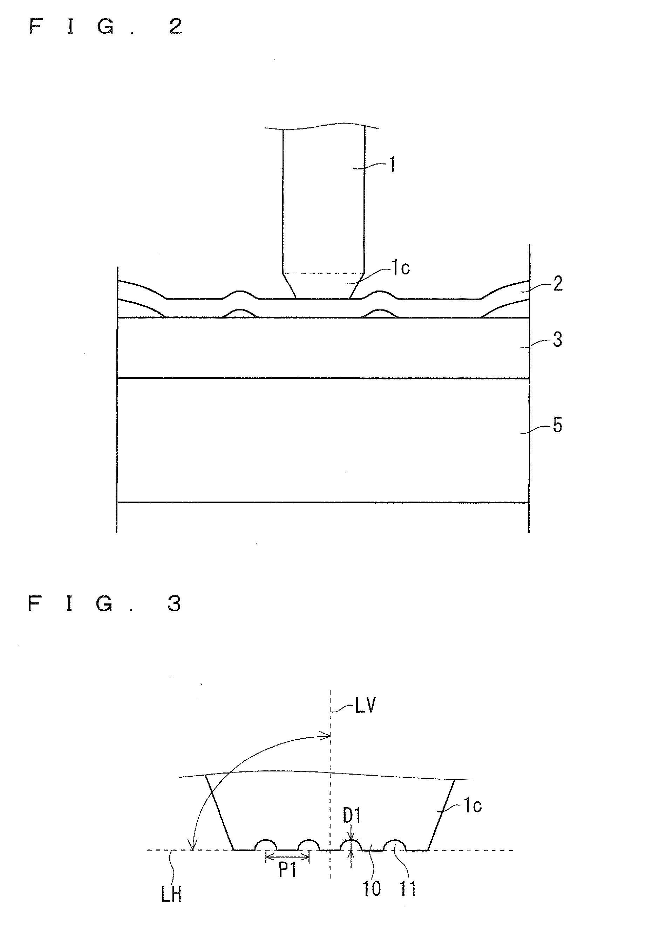

FIG. 2 is a cross-sectional view schematically showing a status of ultrasonic bonding performed by an ultrasonic bonding tool 1 for manufacturing the electrode base according to the embodiment 1 of the present invention.

As shown in FIG. 2, a glass substrate 3 is fixed to a table (anvil) 5, and an aluminum-made lead wire 2 (to-be-bonded member) for external connection having a plate thickness of about 0.1 to 0.2 mm is arranged at a predetermined position on a surface of the glass substrate 3. Then, an ultrasonic bonding operation is performed in which vertical pressure is applied to a bonding surface to be bonded to the lead wire 2 via a chip portion 1c of the ultrasonic bonding tool 1 while the ultrasonic bonding tool 1 is ultrasonically vibrated in a horizontal direction to largely deform the bonding surface. Thereby, the lead wire 2 and the glass substrate 3 are solid-state bonded to each other at a bonding interface between the lead wire 2 and the glass substrate 3.

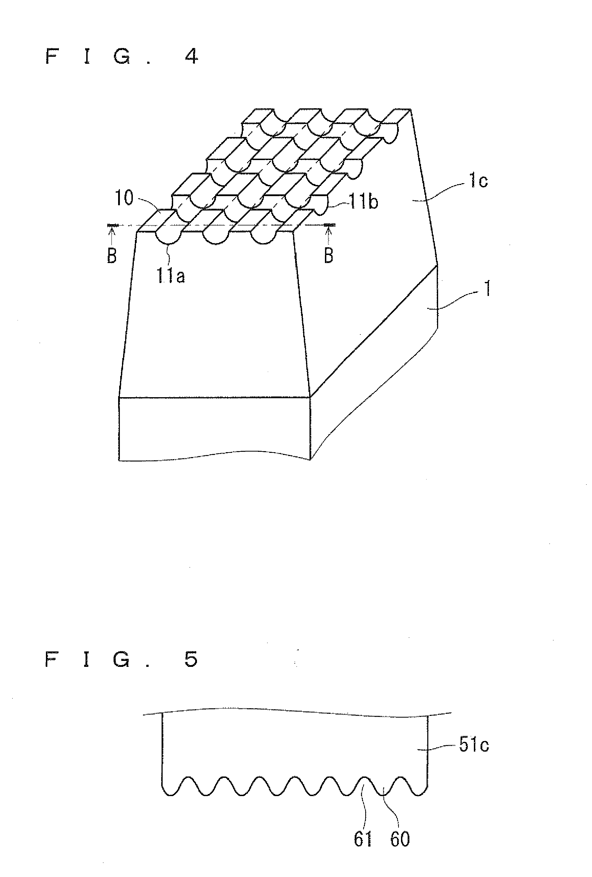

FIG. 3 is a cross-sectional view showing a cross-sectional structure of a surface portion of the chip portion 1c. FIG. 3 is a perspective view schematically showing a planar structure of the surface portion of the chip portion 1c. FIG. 3 corresponds to an inverted version of a cross-section taken along the line B-B of FIG. 4. As shown in FIGS. 3 and 4, on a surface of the chip portion 1c, a plurality of planar portions 10 are formed so as to be separated from one another by a plurality of concavities 11 (in FIG. 4, first grooves 11a and second grooves 11 b).

FIG. 5 is a cross-sectional view showing a cross-sectional structure of a surface portion of an ordinary chip portion 51c of an ultrasonic bonding tool. As shown in FIG. 4, the chip portion 51c has a plurality of planar portions 60 formed so as to be separated from one another by a plurality of concavities 61 by using a wire-cutting process. In general, each of the plurality of planar portions 60 is substantially in the shape of a protrusion, and does not maintain a high degree of flatness. Therefore, as a surface structure of the chip portion 51c, unevenness of a few tens of µm order is formed by the planar portions 60 and the concavities 61. This is not a problem in the conventional method, because a large amount of deformation in a direction of the plate thickness caused by the ultrasonic bonding is acceptable.

On the other hand, in the chip portion 1c of the ultrasonic bonding tool 1 according to embodiment 1. as shown in FIG. 3, a horizontal line LH defined by a plane where surfaces of the planar portions 10 are formed is accurately set to be 90 degrees with respect to the vertical line LV, and the planar portions 10 are accurately formed so as to have a flatness of 2 µm or less. An interval P1 between the concavities 11 and 11 is set to be approximately 1.0 mm or less, and a depth D1 to the innermost of the concavity 11 is set to be approximately 0.15 mm or less. In this manner, the chip portion 1c of the ultrasonic bonding tool 1 for manufacturing the electrode base according to the embodiment 1 is structured with an accuracy completely different from the ordinary ultrasonic bonding tool 51c, and enables the lead wire 2 to be bonded without damaging the glass substrate 3 which is susceptible to fracture.

FIG. 4 shows an example in which the plurality of concavities 11 of FIG. 3 are formed by a plurality of first grooves 11a and a plurality of second grooves 11b that cross each other in the vertical direction. That is, the concavities 11 are formed in a matrix by being separated from each other by the plurality of first grooves 11a provided substantially in a longitudinal direction in FIG. 3 and the second grooves 11b provided in a lateral direction in FIG. 3, so that the plurality of planar portions 10 each having a rectangular shape in a plan view are formed. The plurality of planar portions 10 define a single surface having a flatness of 2 µm or less.

Hereinafter, an effect obtained by the chip portion 1c of the ultrasonic bonding tool 1 shown in FIGS. 2 to 4 will be described in comparison with the ordinary chip portion 51c shown in FIG. 5.

In a case of the ordinary chip portion 51c, as described above, an uneven shape of a few tens of µm order is formed as the surface structure, and therefore if the ultrasonic bonding of FIG. 2 is performed using an ultrasonic bonding tool having the chip portion 51c instead of the ultrasonic bonding tool 1, a concentrated load acts on the planar portions 60 that form the protrusions, which places the glass substrate 3 at a high risk of cracking, to make it substantially impossible to bond the lead wire 2 without fracturing the glass substrate 3.

In the chip portion 1c of the ultrasonic bonding tool 1 for manufacturing the electrode base according to embodiment 1, on the other hand, the plurality of planar portions 10 have a highly accurate flatness of 2 µm or less, which can reduce the above-mentioned concentrated load in each of the plurality of planar portions 10. Moreover, since the plurality of planar portions 60 are formed so as to be separated from one another, a stress is distributed among the plurality of planar portions to thereby reduce a stress acting on one planar portion.

Additionally, the plurality of concavities 11 make it easy to hold the lead wire 2 so as not to fall off during the ultrasonic bonding operation performed by the ultrasonic bonding tool 1 (holding function) and to separate the ultrasonic bonding tool 1 from the lead wire 2 after completion of the ultrasonic bonding operation by the ultrasonic bonding tool 1 (separating function).

In this manner, in the ultrasonic bonding tool 1 shown in FIGS. 2 to 4, the surface portion of the chip portion 1c which is brought into contact with the lead wire 2 has the plurality of planar portions 10 separated from one another and the plurality of concavities 11 each formed between the plurality of planar portions. The plurality of planar portions 10 define one plane having a flatness of 2 µm or less.

Therefore, an ultrasonic bonding method using an ultrasonic bonding apparatus having the ultrasonic bonding tool 1 enables the lead wire 2 to be bonded without any trouble on the surface of the glass substrate 3 that is a thin-film base having a plate thickness of 2 mm or less.

Thus, by the ultrasonic bonding method using the ultrasonic bonding tool 1 shown in FIGS. 2 to 4, the lead wire 2 can be bonded without any trouble on the surface of the glass substrate 3 as shown in FIG. 1.

By the ultrasonic bonding method using the ultrasonic bonding tool 1 described above, the external lead-out electrode 23 can be bonded onto one end portion of the lead wire 2 as shown in FIG. 1.

As a result, the electrode base according to the embodiment 1 is obtained in which an electrode structure including the lead wires 2 (first electrode portion: internal signal receiver) and the external lead-out electrodes 23 (second electrode portion: external signal receiver) is formed on the surface of the glass substrate 3 that is a thin-film base having a plate thickness of about 0.7 to 2.0 mm.

In this manner, the electrode base according to the embodiment 1 is completed through two bonding processes based on the ultrasonic bonding method in which the lead wires 2 are bonded to the surface of the glass substrate 3 and the external lead-out electrodes 23 are bonded to part of the lead wires 2.

### (Effect)

The electrode base according to the embodiment 1 has the electrode structure including the lead wires 2 and the external lead-out electrodes 23 formed on the surface of the thin-film glass substrate 3. Such an electrode structure has not been able to be achieved by the conventional ultrasonic bonding method. As described above, the lead wire 2 is made of aluminum, and the external lead-out electrode 23 is made of copper.

The lead wire 2 is made of aluminum, which is better than copper in terms of bonding characteristics on the surface of the glass substrate 3 in the ultrasonic bonding method using the above-described ultrasonic bonding tool 1. This consequently provides an effect that the lead wires 2 can be accurately formed on the surface of the glass substrate 3.

On the other hand, the external lead-out electrode 23 is made of copper, which has better electrical conductivity and lower resistance than aluminum, and therefore provides an effect that better characteristics as the external signal transmission function can be exhibited as compared with using aluminum.

Additionally, since copper has the characteristics of being easily ultrasonic-bonded to an aluminum material, an effect is obtained that the external lead-out electrode 23 can be accurately formed on the surface of one end portion of the lead wire 2 by the ultrasonic bonding method using the above-described ultrasonic bonding tool 1.

Moreover, since the external lead-out electrode 23 is made of copper, an effect is obtained that higher rigidity than aluminum can be exhibited as an output electrode.

### <Embodiment 2>

### (Structure)

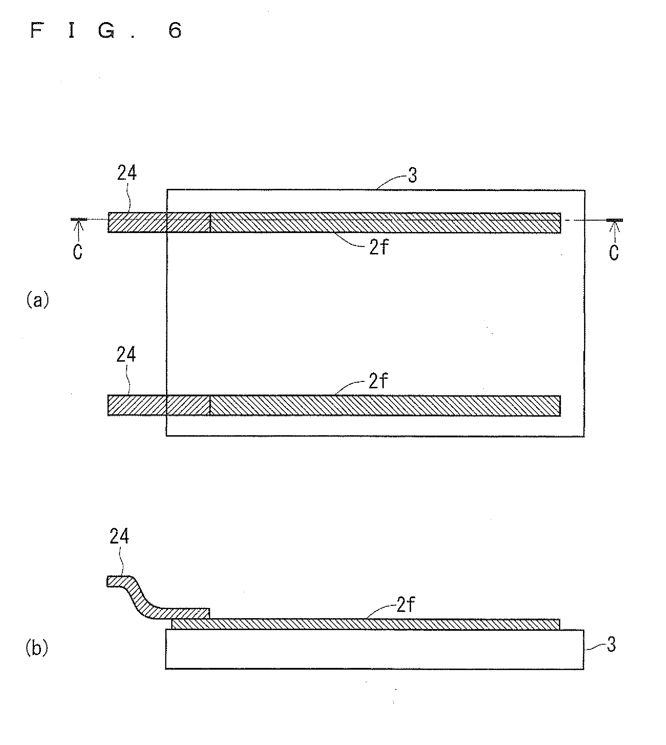

FIG. 6 is an explanatory diagram showing a planar structure and a cross-sectional structure of an electrode base according to an embodiment 2 of the present invention. FIG. 6(a) is a plan view as seen from the upper side, and FIG. 6(b) is a cross-sectional view showing a cross-section taken along the line C-C of FIG. 6(a).

As shown in FIG. 6, lead wires 2f made of a soft aluminum material (O-material) are bonded to the surface of the glass substrate 3 that is a thin-film base having a plate thickness of about 0.7 to 2.0 mm by using the ultrasonic bonding method. Then, external lead-out electrodes 24 (lead wires) made of a hard aluminum material (half hard, quarter hard, (full) hard material) are formed on a surface of one end portion of the lead wires 2f so as to extend to a region outside the glass substrate 3. As shown in FIG. 6(b), in a cross-sectional view, the external lead-out electrode 24 is slightly raised upward along a direction toward the region outside the glass substrate 3.

The lead wire 2f functions as an internal signal receiver for receiving an electrical signal from a circuit or the like provided in the glass substrate 3. Similarly to the external lead-out electrode 23 of the embodiment 1, the external lead-out electrode 24 has an external signal transmission function for at least either one of outputting a signal to the outside and receiving a signal from the outside. In other words, a signal flow includes only one direction (from the glass substrate 3 to the outside or from the outside to the glass substrate 3).

### (Manufacturing Method)

By the ultrasonic bonding method using the ultrasonic bonding tool 1 shown in FIGS. 2 to 4, the lead wires 2f are bonded to the surface of the glass substrate 3, as shown in FIG. 6.

Then, by the ultrasonic bonding method using the above-described ultrasonic bonding tool 1, the external lead-out electrodes 24 are bonded onto the one end portions of the lead wires 2f, as shown in FIG. 6.

As a result, the electrode base according to embodiment 2 is obtained in which an electrode structure including the lead wires 2f (first electrode portion: internal signal receiver) and the external lead-out electrodes 24 (second electrode portion: external signal receiver) is formed on the surface of the glass substrate 3 that is a thin-film base having a plate thickness of about 0.7 to 2.0 mm.

In this manner, the electrode base according to the embodiment 2 is completed through two bonding processes based on the ultrasonic bonding method in which the lead wires 2f are bonded to the surface of the glass substrate 3 and the external lead-out electrodes 24 are bonded to part of the lead wires 2f.

### (Effect)

The electrode base according to the embodiment 2 has the electrode structure including the lead wires 2f and the external lead-out electrodes 24 formed on the surface of the thin-film glass substrate 3. Such an electrode structure has not been able to be achieved by the conventional ultrasonic bonding method. As described above, the lead wire 2f is made of a soft aluminum (O-material), and the external lead-out electrode 24 is made of a hard aluminum material (half hard, quarter hard, (full) hard material). In the aluminum material, relatively increasing a crystal grain provides a soft aluminum material, and relatively reducing the crystal grain provides a hard aluminum material.

The lead wire 2f is made of a soft aluminum material, which is better than a hard aluminum material in terms of bonding characteristics on the surface of the glass substrate 3 in the ultrasonic bonding method using the above-described ultrasonic bonding tool 1. This consequently provides an effect that the lead wires 2f can be accurately formed on the surface of the glass substrate 3.

Since the soft aluminum material has a high plastic deformability, a new surface of aluminum can be obtained by small pressure application that does not cause a damage such as cracking in the glass substrate 3. Therefore, by the ultrasonic bonding, the lead wires 2f can be accurately formed on the surface of the glass substrate 3 having, on a surface thereof, a glass material susceptible to fracture or a film-forming material susceptible to separation.

On the other hand, since the eternal lead-out electrode 24 is made of a hard aluminum material, an effect is obtained that high rigidity can be exhibited as an output electrode.

Additionally, since the soft aluminum material has the characteristics of being easily ultrasonic-bonded to the hard aluminum material, an effect is obtained that the external lead-out electrode 24 can be accurately formed on the surface of one end portion of the lead wire 2f by the ultrasonic bonding method using the above-described ultrasonic bonding tool 1.

### <Embodiment 3>

### (Structure)

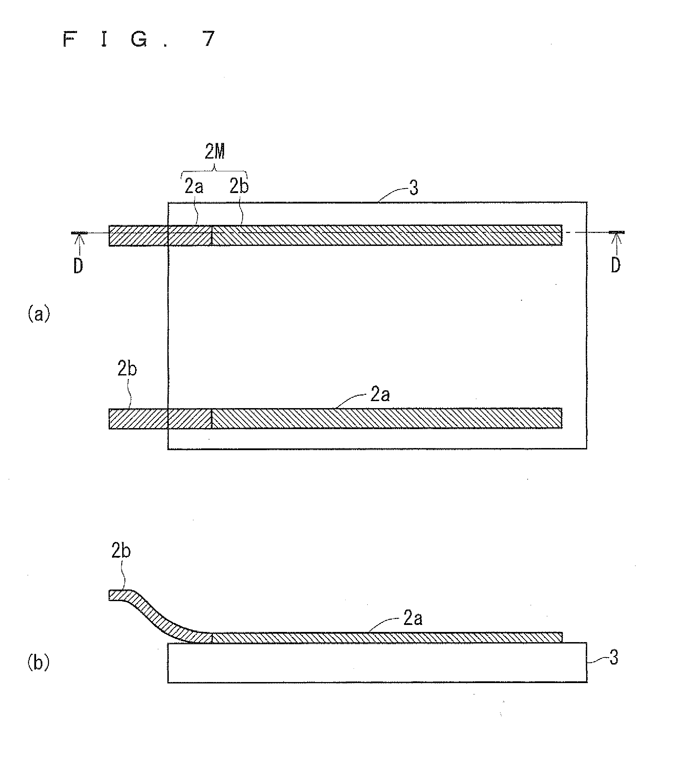

FIG. 7 is an explanatory diagram showing a planar structure and a cross-sectional structure of an electrode base according to an embodiment 3 of the present invention. FIG. 7(a) is a plan view as seen from the upper side, and FIG. 7(b) is a cross-sectional view showing a cross-section taken along the line D-D of FIG. 7(a).

As shown in FIG. 7, by using the ultrasonic bonding method, lead wire soft portions 2a of hard and soft integrated lead wires 2M made of a soft aluminum material (O-material) are bonded on the surface of the glass substrate 3 that is a thin-film base having a plate thickness of about 0.7 to 2.0 mm. A lead wire hard portion 2b (lead-out portion) made of a hard aluminum material is formed so as to be continuous with each lead wire soft portion 2a and so as to extend from an end portion of the lead wire soft portion 2a (lead portion) to a region outside the glass substrate 3. Thus, the hard and soft integrated lead wire 2M has an integrated structure in which the lead wire hard portion 2b is formed continuous with the lead wire soft portion 2a. As shown in FIG. 7(b), in a cross-sectional view, the lead wire hard portion 2b is slightly raised upward along a direction toward the region outside the glass substrate 3.

The lead wire soft portion 2a functions as an internal signal receiver for receiving an electrical signal from a circuit or the like provided in the glass substrate 3. Similarly to the external lead-out electrode 23 of the embodiment 1 and the external lead-out electrode 24 of the embodiment 2, the lead wire hard portion 2b has an external signal transmission function for at least either one of outputting a signal to the outside and receiving a signal from the outside.

### (Manufacturing Method)

By the ultrasonic bonding method using the ultrasonic bonding tool 1 shown in FIGS. 2 to 4, the lead wire soft portion 2a of the hard and soft integrated lead wire 2M and, as necessary, a part of the lead wire hard portion 2b at a boundary with the lead wire soft portion 2a are bonded on the surface of the glass substrate 3, as shown in FIG. 7.

As a result, the electrode base according to the embodiment 3 is obtained in which an electrode structure of the hard and soft integrated lead wire 2M including the lead wire soft portions 2a (first electrode portion: internal signal receiver) and the lead wire hard portions 2b (second electrode portion: external signal receiver) is formed on the surface of the glass substrate 3 that is a thin-film base having a plate thickness of about 0.7 to 2.0 mm.

In this manner, the electrode base according to the embodiment 2 is completed through one bonding processes based on the ultrasonic bonding method in which the lead wires 2f are bonded to the surface of the glass substrate 3.

As a method for manufacturing the hard and soft integrated lead wire 2M, for example, it is conceivable to obtain the hard and soft integrated lead wire 2M in advance by preparing a hard lead wire including only the lead wire hard portion 2b, then selectively performing a heat treatment such as annealing on the hard lead wire to selectively modify the lead wire hard portion 2b into the lead wire soft portion 2a.

### (Effect)

The electrode base according to the embodiment 3 has the electrode structure (the hard and soft integrated lead wire 2M (the lead wire soft portion 2a and the lead wire hard portion 2b)) formed on the surface of the thin-film glass substrate 3. Such an electrode structure has not been able to be achieved by the conventional ultrasonic bonding method. As described above, the lead wire soft portion 2a is made of a soft aluminum (O-material), and the lead wire hard portion 2b is made of a hard aluminum material (half hard, quarter hard, (full) hard material).

The lead wire soft portion 2a is made of a soft aluminum material, which is better than a hard aluminum material in terms of bonding characteristics on the surface of the glass substrate 3 in the ultrasonic bonding method using the above-described ultrasonic bonding tool 1. This consequently provides an effect that the lead wire soft portions 2a can be accurately formed on the surface of the glass substrate 3, similarly to the lead wires 2f of the embodiment 2.

On the other hand, since the lead wire hard portion 2b is made of a hard aluminum material, an effect is obtained that high rigidity can be exhibited as an output electrode.

Additionally, the hard and soft integrated lead wire 2M is formed by the lead wire soft portion 2a and the lead wire hard portion 2b being integrated with each other. This provides an effect that the bonding to the surface of the glass substrate 3 can be made simply by bonding the lead wire soft portion 2a (which may include a part of the lead wire hard portion 2b near the boundary with the lead wire soft portion 2a) of the hard and soft integrated lead wire 2M on the surface of the glass substrate 3, which is a more simple manufacturing method than the embodiments 1 and 2.

### <Others>

In the above-described embodiments, a single-body structure of the glass substrate 3 is mainly shown as the thin-film base. However, needless to say, similarly to the single-body of the glass substrate 3, the present invention is also applicable to a composite structure in which a conductive metal film layer such as a Cr (chromium) or Mo (molybdenum) film layer, a conductive oxide layer such as a ITO, ZnO, or SnO layer, or the like, is laminated on the surface of the glass substrate 3.

Moreover, even in a case of, instead of the glass substrate 3, a substrate made of another material such as a silicon substrate or a ceramic substrate, the present invention is also applicable to the substrate serving as a thin-film base having the above-described single-body structure or composite structure, as long as the substrate is a thin film having a plate thickness of 2 mm or less.

While the invention has been described in detail, the foregoing description is in all aspects illustrative and not restrictive. It is understood that numerous other modifications and variations not illustrated herein can be devised without departing from the scope of the invention.

## Claims

1. An electrode base comprising:
a thin-film base (3);
a first electrode portion (2, 2f, 2a) made of a first material and bonded to a surface of said thin-film base; and
a second electrode portion (23. 24, 2b) made of a second material and electrically connected to said first electrode portion, said second electrode portion having an external signal transmission function for at least either one of outputting a signal to the outside and receiving a signal from the outside,
wherein said first material is better than said second material in terms of bonding characteristics of bonding to said thin-film base by an ultrasonic bonding method.

2. The electrode base according to claim 1, wherein
said second material has better electrical conductivity than that of said first material.

3. The electrode base according to claim 2, wherein
said first material contains an aluminum material,
said second material contains a copper material.

4. The electrode base according to claim 1, wherein
said second material has higher rigidity than that of said first material.

5. The electrode base according to claim 4, wherein
said first material contains a soft aluminum material,
said second material contains a hard aluminum material.

6. The electrode base according to any one of claims 1 to 5, wherein
said second electrode portion (23, 24) is bonded on a part of said first electrode portion (2, 2f).

7. The electrode base according to claim 4 or 5, wherein
said first and second electrode portions (2a, 2b) are integrally formed with each other.

8. The electrode base according to any one of claims 1 to 5, wherein
said thin-film base includes a thin-film base having a plate thickness of 2 mm or less.
